# EUROPEAN PATENT APPLICATION

(11) **EP 2 320 569 A1**
(43) Date of publication of application: **11.05.2011**
(21) Application number: 09252521.1
(22) Date of filing: 30.10.2009
(51) Int. Cl.: H03K 19/003, H01L 27/02, H02H 9/04

(54) **Electrostatic discharge protection**

(71) Applicant: ST-Ericsson SA, Geneva (CH)
(72) Inventor: Notermans, Guido, Zurich (CH); Maksimovic, Dejan, 8952 Schlieren (CH); Mrcarica, Zeljko, 8049 Zurich (CH)
(74) Representative: Gray, Peter John Bracey

(57) **Abstract**

An integrated circuit (300) protected from an electrostatic discharge has one or more positive interconnection means (306d, 306d, 306i) for electrically coupling the integrated circuit (300) externally to the integrated circuit (300) at a voltage that is solely positive with respect to a common conductor (CC) and one or more negative interconnection means (306f-h) for electrically coupling the integrated circuit (300) externally to the integrated circuit (300) at a voltage that is solely negative with respect to the common conductor (CC). Each of the positive and negative interconnection means (306d-i) is electrically coupled to the common conductor (CC) via a different electrostatic discharge protection device (312d-i). Between each combination of two of the interconnection means (306d-i) is a path for conducting the electrostatic discharge current comprising the common conductor (CC) and no more than two of the electrostatic discharge protection devices (312d-i).

## Description

### Field of the Disclosure

The present disclosure relates to the protection of an integrated circuit from an electrostatic discharge. The disclosure is particularly applicable to an integrated circuit (IC) operable using positive and negative supply voltages.

### Background to the Disclosure

ICs are prone to be damaged by an electrostatic discharge (ESD) and therefore there is a requirement to provide protection against ESD. One scheme for ESD protection used in advanced Complementary Metal Oxide Semiconductor (CMOS) technologies is a voltage rail based protection scheme.

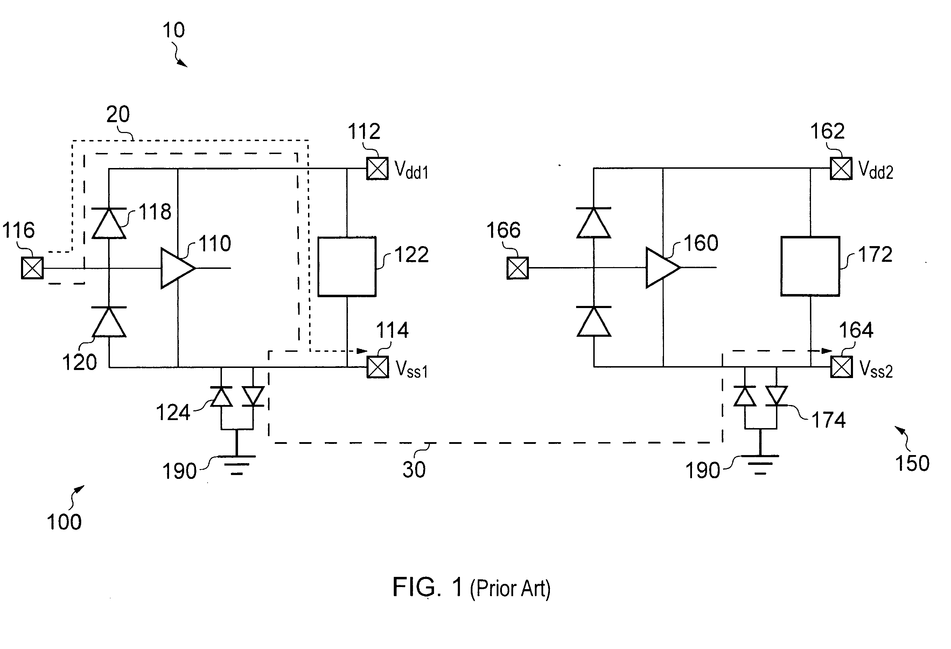

Referring to Figure 1, an IC 10 incorporating such a scheme comprises a first circuit 100 and a second circuit 150. The first and second circuits 100, 150 each form different domains of the IC 10, in that they each have their own voltage supply.

The first circuit 100 has a core circuit 110 that is coupled to a first interconnection pin 112 at a first supply voltage V_{dd1}, and to a second interconnection pin 114 at a second supply voltage Vₛₛ₁. The core circuit 110 has an input coupled to a third interconnection pin 116 for supplying a signal to the core circuit 110 from an external apparatus. Coupled between the input of the core circuit 110 and the first interconnection pin 112 is a first diode 118 arranged to permit the flow of current from the third interconnection pin 116 to the first interconnection pin 112. Coupled between the input of the core circuit 110 and the second interconnection pin 114 is a second diode 120 arranged to permit the flow of current from the second interconnection pin 114 to the third interconnection pin 116. Coupled between the second interconnection pin 114 and a substrate 190 of the integrated circuit 10 is a pair of anti-parallel diodes 124. Coupled between the first interconnection pin 112 and the second interconnection pin 114 is a clamp 112 for protecting against ESD. The clamp 122 provides ESD protection for the core circuit 110 by providing a relatively low impedance path for an ESD current between pairs of the first to third interconnection pins 112, 114, 116, ensuring that the ESD current bypasses the core circuit 110. In Figure 1, the dashed line 20 illustrates the path of an ESD current from the third interconnection pin 116 to the second interconnection pin 114.

The second circuit 150 has an identical structure to the first circuit 100 and operates in an identical manner. In particular, second circuit 150 has a fourth interconnection pin 162 at a third supply voltage V_{dd2}, a fifth interconnection pin 164 at a fourth supply voltage V_{SS2} and a sixth interconnection pin 166 for supplying a signal to a core circuit 160, each of the interconnection pins 162, 164, 166 corresponding with the first, second and third interconnection pins 112, 114, 116 of the first circuit 100 respectively. The second circuit 150 also has diodes 168, 170, a clamp 172 and a pair of anti-parallel diodes 174 corresponding with the diodes 118, 120, clamp 122 and pair of anti-parallel diodes 114 of the first circuit 100. The substrate 190 of the first circuit 100 is also the substrate of the second circuit 150, being formed of the same substrate 190 of the IC 10. The substrate 190 therefore couples the first and second circuits 100, 150 via the pairs of anti-parallel diodes 124, 174. The pairs of anti-parallel diodes 124, 174 prevent unwanted signals, e.g. noise, from passing between the circuits 100, 150. However, in the event of an ESD taking place between one of the first to third interconnection pins 112, 114, 116 of the first circuit 100 and one of the fourth to sixth interconnection pins 162, 164, 166 of the second circuit 150, the pairs of anti-parallel diodes 124, 174 and the substrate 190 provide a path for the ESD. In Figure 1, the dashed line 30 illustrates a path of an ESD current from the third interconnection pin 116 of the first circuit 100 to the fifth interconnection pin 164 of the second circuit 150.

ESD protection is therefore provided between all possible pairs of the interconnection pins 112, 114, 116, 162, 164, 166 of the two circuits 100, 150.

The clamps 170, 172 are devices that have a very high impedance in the absence of an electrostatic voltage and which therefore permit normal operation of the core circuits 110, 160, but which, in response to an electrostatic voltage, switch to a low impedance state to be able to sink the current which flows during an ESD. The clamps 170, 172 are designed such that they are not destroyed by the ESD current, such that the voltage drop across them remains sufficiently low during an ESD to prevent damage to the core circuits 110, 160, and such that they return to their very high impedance after the ESD.

In advanced IC technologies a deep nwell layer is available, which makes it possible to isolate parts of an IC. The isolation in turn makes it possible to use domains which have first supply voltages that are positive with respect to the substrate of the IC and second supply voltages that are negative with respect to the substrate of the IC. Signals in such a domain may have a dual polarity centred around the voltage of the substrate. In some applications, the use of dual polarity signals has advantages, such as a reduction in the number of components that are required external to the IC. However, ESD protection scheme described with reference to Figure 1 cannot be used with such an IC because the pairs of anti-parallel diodes 124, 174 short-circuit the second and fourth supply voltages Vₛₛ₁ and Vₛₛ₂ to the substrate 190 and these voltages cannot therefore be maintained more negative with respect to the voltage of the substrate 190 than the voltage drop across one of the pairs of anti-parallel diodes 124, 174, e.g. about 0.7V.

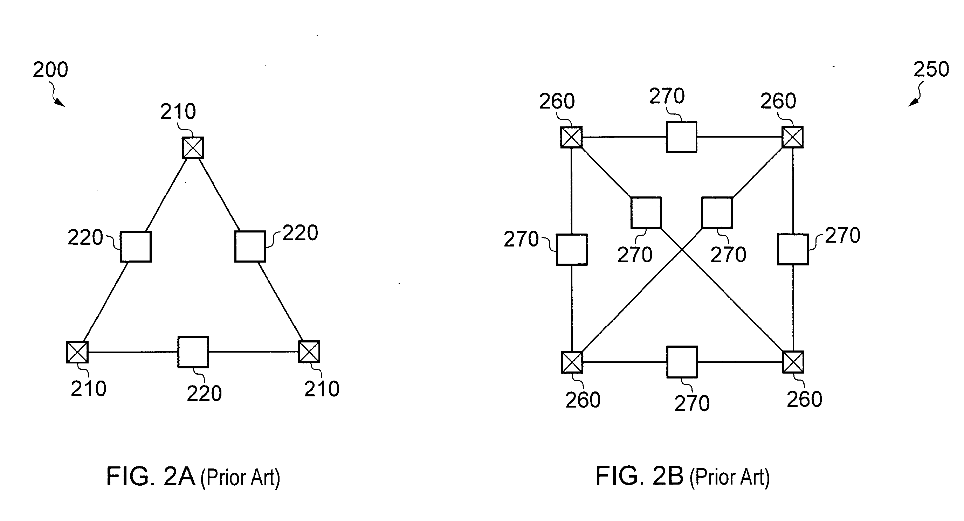

One scheme for providing ESD protection to ICs having both supply voltages that are both positive and negative with respect to the voltage of the substrate is to couple every interconnection pin to every other interconnection pin by means of a clamp, that is to provide one clamp for each combination of two interconnection pins. Such a scheme is illustrated in simplified form in Figure 2A for a circuit 200 having three interconnection pins 210 which requires three clamps 220, and in Figure 2B for a circuit 270 having four interconnection pins 260, which requires six clamps 270. Although in some applications it may be possible to protect more than one combination of interconnection pins by a single clamp, in general the required number of clamps in this scheme increases rapidly as the number of interconnection pins increases.

Apart from the disadvantage of requiring an increasingly large chip area as the number of clamps increases, the design process of inserting a clamp between each combination of two interconnection pins can be prone to error by the omission of essential clamps, because of the large number of combinations of interconnection pins, and because the process of attempting to eliminate surplus clamps can be prone to error. Furthermore, the scheme cannot be generalised easily because the scheme generally has to be customised for each different integrated circuit.

### Summary of the Preferred Embodiments

According to a first aspect, there is provided an integrated circuit comprising:
one or more positive interconnection means for coupling the integrated circuit externally to the integrated circuit at a voltage that is solely positive with respect to a common conductor;
one or more negative interconnection means for coupling the integrated circuit externally to the integrated circuit at a voltage that is solely negative with respect to the common conductor; and
a plurality of electrostatic discharge protection devices for conducting an electrostatic discharge current during the electrostatic discharge;
wherein the positive and negative interconnection means are each electrically coupled to the common conductor via a different one of the electrostatic discharge protection devices such that between each combination of two of the interconnection means is a first path for conducting the electrostatic discharge current, each first path comprising the common conductor and no more than two of the electrostatic discharge protection devices.

According to a second aspect, there is provided a method of protecting an integrated circuit from an electrostatic discharge, the integrated circuit comprising one or more positive interconnection means for electrically coupling the integrated circuit externally to the integrated circuit at a voltage that is solely positive with respect to a common conductor and one or more negative interconnection means for electrically coupling the integrated circuit externally to the integrated circuit at a voltage that is solely negative with respect to the common conductor, the method comprising employing a plurality of electrostatic discharge protection devices for conducting an electrostatic discharge current by electrically coupling each of the positive and negative interconnection means to the common conductor via a different one of the electrostatic protection devices such that between each combination of two of the interconnection means is a first path for conducting the electrostatic discharge current, each first path comprising the common conductor and no more than two of the electrostatic discharge protection devices.

In this way protection can be provided against an electrostatic discharge between different combinations of two of the interconnection means by employing the common conductor to couple electrostatic discharge protection devices and to provide a path for an electrostatic discharge current. It may be that every positive and negative interconnection means of the integrated circuit is coupled to the common conductor via a different one of the electrostatic protection devices. Alternatively, it is envisaged that just some of the positive and negative interconnection means of the integrated circuit may be so connected.

The positive and negative interconnection means may all be associated with a single domain of the integrated circuit. For example, every positive and negative interconnection means of a domain of the integrated circuit may be coupled to the common conductor via a different one of the electrostatic protection devices.

Each of the interconnection means may be considered as being associated with one electrostatic discharge protection device. The number of electrostatic discharge protection devices required for protecting against electrostatic discharge does not therefore need to exceed the number of the positive and negative interconnection means. In this way the number of electrostatic discharge protection devices, and consequently the chip area of the integrated circuit, can be small. Also, the design process can be reliable, due to the simple arrangement of electrostatic discharge protection devices.

Optionally, each of the electrostatic discharge protection devices coupled between the positive and negative interconnection means comprises a first terminal, a second terminal, a first protection element coupled between the first and second terminals and a second protection element coupled between the first and second terminals, wherein:
the first protection element is arranged to present a relatively high impedance in the absence of an electrostatic voltage between the first and second terminals and to switch temporarily to a relatively low impedance for conducting the electrostatic discharge current from the first terminal to the second terminal in the presence of the electrostatic voltage;
the second protection element is arranged to present a relatively high impedance from the first terminal to the second terminal and a relatively low impedance from the second terminal to the first terminal for conducting the electrostatic discharge current from the second terminal to the first terminal in the presence of the electrostatic voltage; and
for each one of the electrostatic discharge protection devices coupled between the positive and negative interconnection means the first and second terminals are coupled in one of:
   a first configuration in which the first terminal is coupled to one of the positive interconnection means and the second terminal is coupled to the common conductor; and
   a second configuration in which the first terminal is coupled to the common conductor and the second terminal is coupled to one of the negative interconnection means.

Likewise, the method can optionally comprise providing each of the electrostatic discharge protection devices coupled between the positive and negative interconnection means with a first terminal, a second terminal, a first protection element coupled between the first and second terminals and a second protection element coupled between the first and second terminals,
arranging the first protection element to present a relatively high impedance in the absence of an electrostatic voltage between the first and second terminals and to switch temporarily to a relatively low impedance for conducting the electrostatic discharge current from the first terminal to the second terminal in the presence of the electrostatic voltage;
arranging the second protection element to present a relatively high impedance from the first terminal to the second terminal and a relatively low impedance from the second terminal to the first terminal for conducting the electrostatic discharge current from the second terminal to the first terminal in the presence of the electrostatic voltage; and
for each one of the electrostatic discharge protection devices coupled between the positive and negative interconnection means, coupling the first and second terminals in one of:
a first configuration in which the first terminal is coupled to one of the positive interconnection means and the second terminal is coupled to the common conductor; and
a second configuration in which the first terminal is coupled to the common conductor and the second terminal is coupled to one of the negative interconnection means

In other words, the electrostatic discharge protection devices may be bi-directional, in that they conduct an electrostatic discharge current in either direction between the first and second terminals. In one direction, the electrostatic discharge protection devices may be switchable, so as to prevent the flow of current except in the presence of an electrostatic voltage. In the other direction, current may flow freely. Nevertheless, the electrostatic discharge protection devices can be coupled so as to prevent any current flowing in the absence of an electrostatic voltage.

Optionally, a part of the integrated circuit to be protected from the electrostatic discharge has a breakdown voltage V_{B} at which damage is caused to the part, each electrostatic discharge protection device coupling the positive and negative interconnection means to the common conductor, when conducting the electrostatic discharge current from the first terminal to the second terminal has a first voltage drop of V_{HL} and when conducting the electrostatic discharge current from the second terminal to the first terminal has a second voltage drop V_{LH}, and both twice the first voltage drop V_{HL} and twice the second voltage drop V_{LH} are less than the breakdown voltage V_{B}.

This feature enables electrostatic discharge protection to be provided for the part to be protected by a single design of electrostatic discharge device for all possible pairs of the positive and negative interconnection means.

Optionally, the first protection element can comprise a switchable transistor and the second protection element can comprise a diode. This feature enables the electrostatic discharge protection device to have a simple design and to occupy a small area of the integrated circuit.

Optionally, the integrated circuit comprises a dual polarity interconnection means for coupling the integrated circuit externally to the integrated circuit at a voltage that varies between positive and negative with respect to the common conductor,
wherein the dual polarity interconnection means is coupled to one of the positive interconnection means via another different one of the electrostatic discharge protection devices and is coupled to one of the negative interconnection means via yet another different one of the electrostatic discharge protection devices such that between the dual polarity interconnection means and the positive interconnection means is a second path for conducting the electrostatic discharge current, and between the dual polarity interconnection means and the negative interconnection means is another second path for conducting the electrostatic discharge current, each second path comprising no more than one of the electrostatic discharge protection devices.

In other words, the dual polarity interconnection means can be coupled to one of the positive and one of the negative first interconnection means by respective electrostatic discharge protection devices. These electrostatic discharge protection devices provide a path to the common conductor via the electrostatic discharge protection devices coupled between the positive and negative interconnection means and the common conductor. This feature also contributes to a small number of electrostatic discharge protection devices being required.

Optionally, the one of the positive interconnection means to which the dual polarity interconnection means is coupled is at a voltage that is a positive supply voltage for the part of the integrated circuit to be protected from the electrostatic discharge and the one of the negative interconnection means to which the dual polarity interconnection means is coupled is at a voltage that is a negative supply voltage for the part of the integrated circuit to be protected from an electrostatic discharge. The positive supply voltage and negative supply voltage may respectively be the most positive and most negative supply voltages of the integrated circuit.

Each of the electrostatic discharge protection devices coupled between the dual polarity interconnection means and the ones of the positive and negative interconnection means may comprise a first terminal, a second terminal, a first protection element coupled between the first and second terminals and a second protection element coupled between the first and second terminals, wherein:
the first protection element is arranged to present a relatively high impedance in the absence of an electrostatic voltage between the first and second terminals and to switch temporarily to a relatively low impedance for conducting the electrostatic discharge current from the first terminal to the second terminal in the presence of the electrostatic voltage;
the second protection element is arranged to present a relatively high impedance from the first terminal to the second terminal and a relatively low impedance to from the second terminal to the first terminal for conducting the electrostatic discharge current from the second terminal to the first terminal in the presence of the electrostatic voltage; and
for each one of the electrostatic discharge protection devices coupled between the dual polarity interconnection means and the ones of the positive and negative interconnection means, the first and second terminals are coupled in one of:
   a first configuration in which the first terminal is coupled to the dual polarity interconnection means and the second terminal is coupled to the one of the negative voltage interconnection means; and
   a second configuration in which the first terminal is coupled to the one of the positive voltage interconnection means and the second terminal is coupled to the dual polarity interconnection means.

Optionally, the part of the integrated circuit to be protected from the electrostatic discharge has the breakdown voltage V_{B} at which damage is caused to the part, each electrostatic discharge protection device coupled between the dual polarity interconnection means and the positive and negative interconnection means, when conducting the electrostatic discharge current from the first terminal to the second terminal has the first voltage drop of V_{HL} and when conducting the electrostatic discharge current from the second terminal to the first terminal has the second voltage drop V_{LH}, and both the total of the second voltage drop V_{LH} plus twice the first voltage drop V_{HL} and the total of the first voltage drop V_{HL} plus twice the second voltage drop V_{LH} are each less than the breakdown voltage V_{B}.

This feature enables electrostatic discharge protection to be provided for the part to be protected by a single design of electrostatic discharge device for all possible pairs of the positive, negative and dual polarity interconnection means. In other words, all of the electrostatic discharge protection devices may have substantially the same voltage drops when conducting the electrostatic discharge current.

The common conductor may be a conducting layer of the integrated circuit. Optionally, the common conductor comprises a substrate of the integrated circuit. This feature means that the integrated circuit need not include a conducting layer dedicated to ESD protection, but can utilise the substrate already present in most integrated circuits. Furthermore, use of the substrate can provide straightforward coupling between domains of the integrated circuit for electrostatic discharge protection.

### Brief Description of the Drawings

Preferred embodiments will now be described, by way of example only, with reference to the accompanying drawings, in which:
Figure 1 is an illustration of an ESD protection scheme according to the prior art;
Figures 2A and 2B are illustrations of arrangements of clamps in another ESD protection scheme according to the prior art;
Figure 3 is a schematic illustration of an integrated circuit having ESD protection according to a preferred embodiment of the present disclosure; and
Figure 4 is a circuit diagram of a clamp of the integrated circuit illustrated in Figure 3.

### Detailed Description of Preferred Embodiments

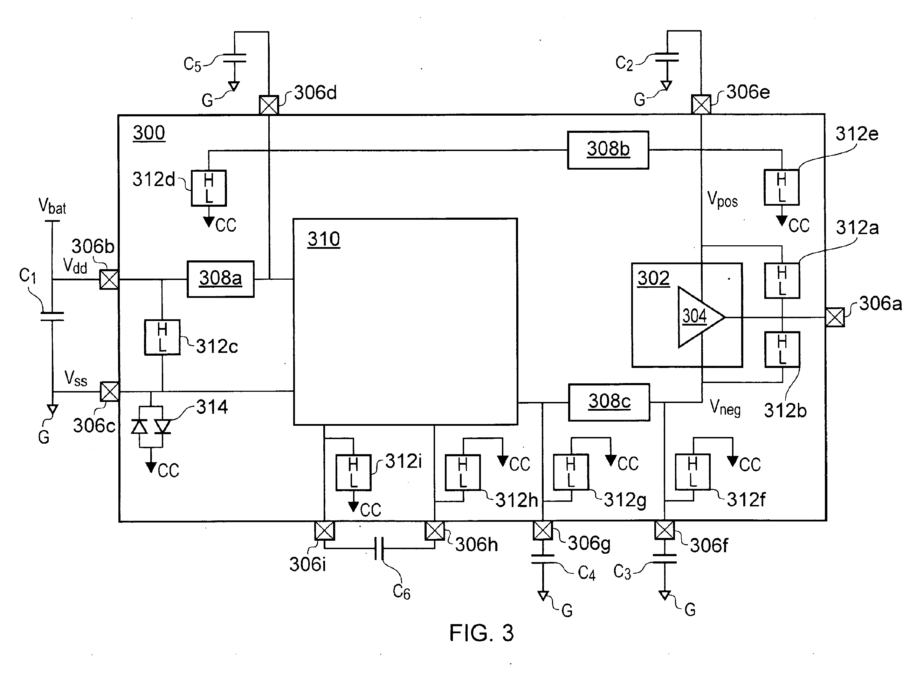

Referring to Figure 3, an integrated circuit 300 with ESD protection has a core circuit 302 including an audio amplifier 304 with an output coupled to a first interconnection pin 306a for delivering a dual polarity stereo audio signal to headphones (not shown). An input to the audio amplifier 304 is present in practice, but has been omitted from Figure 3 for clarity. The core circuit 302 is powered by a first positive supply voltage Vₚₒₛ and a first negative supply voltage V_{neg}. The positive supply voltage Vₚₒₛ and the negative supply voltage V_{neg} are positive and negative respectively with respect to a voltage Vₛₛ of a substrate of the integrated circuit 300, which is coupled to a ground G.

A second interconnection pin 306b couples a battery (not shown) having a battery voltage V_{bat} to the integrated circuit 300. The battery voltage V_{bat} provides a second positive supply voltage V_{dd} to the integrated circuit 300. A first capacitor C₁ external to the integrated circuit 300 is coupled between the second interconnection pin 306b and a third interconnection pin 306c. The third interconnection pin 306c is coupled to the ground G and the first capacitor C₁ is operable to smooth the positive supply voltage V_{dd} during changes in load.

A first low dropout regulator (LDO) 308a has an input coupled to the second interconnection pin 306b and an output coupled to an input of a second LDO 308b, to an input of a charge pump inverter 310, and to a fourth interconnection pin 306d. An output of the second LDO 308b delivers the first positive supply voltage Vₚₒₛ to the core circuit 302. A second capacitor C₂ external to the integrated circuit 300 is coupled between the ground G and the output of the second LDO 308b via a fifth interconnection pin 306e for smoothing the first positive supply voltage Vₚₒₛ.

An output of the charge pump inverter 310 delivers a negative voltage and is coupled to third LDO 308c. An output of the third LDO 308c delivers the first negative supply voltage V_{neg} to the core circuit 302. A third capacitor C₃ external to the integrated circuit 300 is coupled between the ground G and the output of the third LDO 308c via a sixth interconnection pin 306f for smoothing the first negative supply voltage V_{neg}. Further smoothing is provided by a fourth capacitor C₄ external to the integrated circuit 300 that is coupled between the ground G and the output of the charge pump inverter 310 via a seventh interconnection pin 306g and by a fifth capacitor C₅ external to the integrated circuit that is coupled between the ground G and the input of the charge pump inverter 310 via the fourth interconnection pin 306d. A sixth capacitor C₆ external to the integrated circuit 300 is coupled between eighth and ninth interconnection pins 306h, 306i. Each of the eighth and ninth interconnection pins 306h, 306i is coupled to the charge pump inverter 310 and the sixth capacitor C₆ is employed by the charge pump inverter 310 to generate the negative voltage.

First to ninth clamps 312a-i are provided for protecting the against circuit overload in the event of an ESD. Each clamp 312a-i is an example of what is referred to elsewhere in this specification as an ESD protection device.

The first interconnection pin 306a couples a signal having a dual polarity with respect to the voltage Vₛₛ of the substrate, and is an example of what is referred to elsewhere in this specification as a dual polarity interconnection means. The first interconnection pin 306a is coupled to the positive supply voltage Vₚₒₛ via the first clamp 312a and is coupled to the negative supply voltage V_{neg} via the second clamp 312b. For clarity, only one audio amplifier 304 is shown in Figure 3, but in practice another audio amplifier is present. The other audio amplifier is connected in the same way as the audio amplifier 304 shown in the drawings to the positive and negative supply voltages Vₚₒₛ, V_{neg} via other clamps.

The second interconnection pin 306b is coupled to the common conductor CC via the third clamp 312c in series with a pair of anti-parallel diodes 314. The third interconnection pin 306c, which in this embodiment is connected to the ground G, is connected to the common conductor CC via the pair of anti-parallel diodes 314. The common conductor CC therefore remains at a common conductor voltage V_{cc} that is within a voltage drop of the pair of anti-parallel diodes 314 of the voltage Vₛₛ of the substrate of the integrated circuit 300. The anti-parallel diodes reduce unwanted signals between the substrate and the common conductor CC.

Each of the fourth to ninth interconnection pins 306d-i is connected to the common conductor CC via one of the fourth to ninth clamps 312d-i respectively. In this embodiment, each of the fourth to ninth interconnection pins 306d-i is connected directly to the common conductor CC by the corresponding one of the fourth to ninth clamps 312d-i, without any circuit components being present between each pin 306d-i and clamp 312d-i. In other embodiments, components not requiring ESD protection can be present between the pins 306d-i and clamps 312d-i, if desired.

In operation, each of the second and fourth to ninth interconnection pins 306b, 306d-i are at respective voltages that each have a single polarity with respect to voltage Vₛₛ of the substrate. In particular, in this embodiment, second, fourth, fifth and ninth interconnection pins 306b, 306d, 306e, 306i are at voltages that are positive with respect to the voltage Vₛₛ of the substrate, and are examples of what is referred to elsewhere in this specification as positive interconnection means. Sixth to eighth interconnection pins 306f-h are at voltages that are negative with respect to the voltage Vₛₛ of the substrate SS, and are examples of what is referred to elsewhere in this specification as negative interconnection means.

Each of the first to ninth clamps 312a-i has a high terminal H and a low terminal L, and can conduct an ESD current in either direction, from the high terminal H to the low terminal L, or from the low terminal L to the high terminal H. Each clamp 412a-i is coupled such that its high terminal H under normal operating conditions, that is in the absence of an electrostatic charge, is coupled to a voltage that is higher than the voltage at the low terminal L. When conducting an ESD current in the direction from the high terminal H to the low terminal L, there is a first voltage drop V_{HL} across the clamp 412a-i. When conducting an ESD current in the direction from the low terminal L to the high terminal H, there is a second voltage drop V_{LH} across the clamp 412a-i.

An ESD current flowing between any two of the fourth to ninth interconnection pins 306d-i passes through two of the fourth to ninth clamps 312d-i and the common conductor. The direction of the ESD current can be from the high terminal H to the low terminal L of either or both of the two clamps 312d-i or from the low terminal L to the high terminal H of either or both of the two clamps 312d-i. For example, an ESD current flowing from the eighth interconnection pin 306h to the fifth interconnection pin 306e flows through eighth clamp 312h from its low terminal L to its high terminal H, through the common conductor to the fifth clamp 312e, and through the fifth clamp 312e from its low terminal L to its high terminal H to the fifth interconnection pin 306e. During the flow of this ESD current, the voltage difference between the eighth and fifth interconnection pins 306h, 306e is twice the second voltage drop V_{LH}, assuming negligible voltage drop across the common conductor CC. In general, the maximum voltage drop between any two of the fourth to ninth interconnection pins 306d-i is the larger of twice the first voltage drop V_{HL} and twice the second voltage drop V_{LH}. Therefore, ESD protection is provided to the core circuit 302 or charge pump inverter 310 to be protected provided a breakdown voltage V_{B} at which damage occurs to the core circuit 302 or charge pump inverter 310 is greater than this maximum voltage drop. In other words, the fourth to ninth ESD protection devices 312d-i should each have a voltage drop that is below this maximum, or more specifically, first and second voltage drops V_{HL}, V_{LH} that are both less than half the breakdown voltage V_{B}. In practice some account should also ideally be taken of the voltage drop across the common conductor CC or elsewhere, so the first and second voltage drops V_{HL}, V_{LH} are both less than half the breakdown voltage V_{B} by a margin.

An ESD current flowing between the first interconnection pin 306a and either the fifth or sixth interconnection pins 306e, 306f passes through just a single one of the first or second clamps 312a, 312b. More specifically, an ESD current flowing between the first interconnection pin 306a and the fifth interconnection pin 306e passes through just the first clamp 312a and an ESD current flowing between the first interconnection pin 306a and the sixth interconnection pin 306f passes through just the second clamp 312b. The voltage drop across the single one of the first or second clamps 312a, 312b during ESD is equal to either the first voltage drop V_{HL} or the second voltage drop V_{LH}, depending on the direction in which the ESD current flows.

An ESD current flowing between the first interconnection pin 306a and any of the fourth and seventh to ninth interconnection pins 306d, 306g-i passes through one of the first or second clamps 312a, 312b and two of the fourth and seventh to ninth clamps 312d, 312g-i. For example, an ESD current flowing from the first interconnection pin 312a to the seventh interconnection pin 306g can pass through the first clamp 312a to the fifth clamp 312e, through the fifth clamp 312e to the common conductor CC, through the common conductor CC to the seventh clamp 312g, and through the seventh clamp 312g to the seventh interconnection pin 306g. Alternatively, the ESD current can pass through the second clamp 312b to the sixth clamp 312f, through the sixth clamp 312f to the common conductor CC, through the common conductor CC to the seventh clamp 312g, and through the seventh clamp 312g to the seventh interconnection pin 306g. In either case, the voltage drop from the first interconnection pin 306a to the seventh interconnection pin 306g during the ESD is therefore the sum of the second voltage drop V_{LH} and twice the first voltage drop V_{HL}, assuming a negligible voltage drop across the ground. As another example, an ESD current flowing from the first interconnection pin 306a to the fourth interconnection pin 306d can pass through first clamp 312a to fifth clamp 312e, through the fifth clamp 312e to the common conductor CC, through the common conductor CC to the fourth clamp 312d, and through the fourth clamp 312d to the fourth interconnection pin 306d. Alternatively, the ESD current can pass through second clamp 312b to the sixth clamp 312f, through the sixth clamp 312f to the common conductor CC, through the common conductor CC to the fourth clamp 312d, and through the fourth clamp 312d to the fourth interconnection pin 306d. In either of these cases, the voltage drop from the first interconnection pin 306a to the fourth interconnection pin 306d during the ESD is the sum of the first voltage drop V_{HL} and twice the second voltage drop V_{LH}, assuming a negligible voltage drop across the common conductor CC.

In general, the maximum voltage drop between the first interconnection pin 306a and any of the fourth to ninth interconnection pins 306d-i is the larger of the sum of the second voltage drop V_{LH} and twice the first voltage drop V_{HL} and the sum of the first voltage drop V_{HL} and twice the second voltage drop V_{LH}. Therefore, ESD protection is provided to the core circuit 302 or charge pump inverter 310 to be protected provided a breakdown voltage V_{B} at which damage occurs to the core circuit 302 or charge pump inverter 310 is greater than this maximum voltage drop. In other words, the first, second and fourth to ninth ESD protection devices 312a, 312b, 312d-i should meet this criteria. Again, some account should also ideally be taken of the voltage drop across the common conductor CC or elsewhere, so the maximum voltage drop should be less than the breakdown voltage V_{B} by a margin.

For an ESD involving the second interconnection means 306b, the maximum requirement includes additionally a voltage drop occurring across the third ESD protection device 312c in place of the first or second voltage drop V_{LH}, V_{HL} across one of the fourth to ninth ESD protection devices 312d-i and the voltage drop anti-parallel diodes 314. For an ESD involving the third interconnection means 306c, the maximum requirement includes the voltage drop occurring across the anti-parallel diodes 314, and the voltage drop across either just one of the fourth to ninth ESD protection devices 312d-i or one of the fourth to ninth ESD protection devices 312d-i and one of the first and second ESD protection devices 312a, 312b.

In embodiments that employ more than one positive supply voltage or more than one negative supply voltage, it is preferable that the first interconnection pin 306a for conveying a dual polarity signal is coupled via a clamp to the supply voltages of highest available magnitude, as the dual polarity signal may vary between the supply voltages of the highest magnitude and coupling to a lower voltage may therefore lead to the generation of parasitic currents.

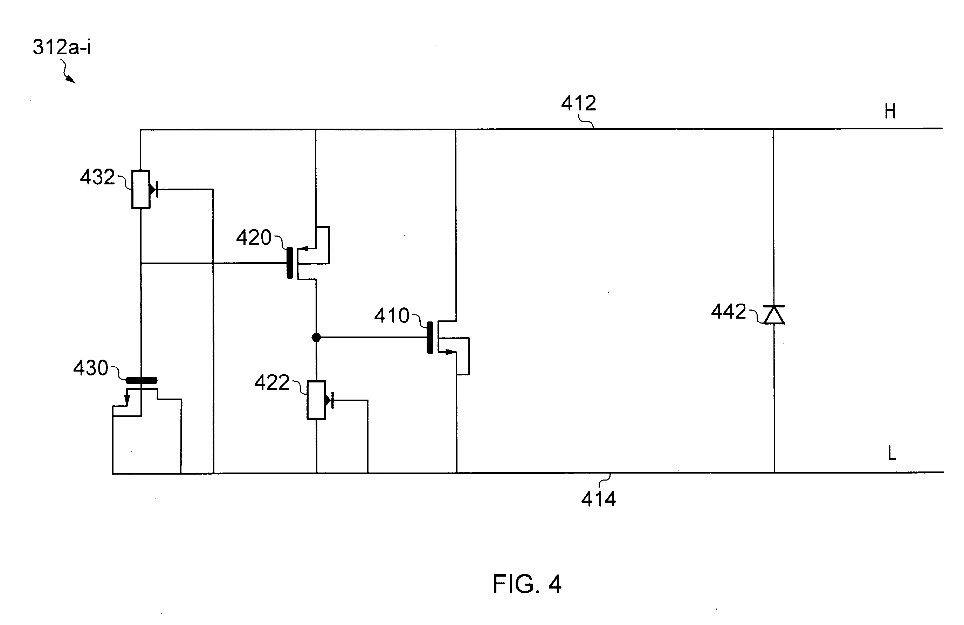

Referring to Figure 4, each of the first to seventh clamps 312a-i comprises a bigFET 410 with its drain coupled to a positive voltage supply rail 412 and its source coupled to a negative voltage supply rail 414. The bigFET 410 comprises an n-type metal oxide semiconductor field effect transistor (MOSFET) able to handle relatively high currents and, in this embodiment, having a channel with between around 3mm and 5mm. The positive voltage supply rail 412 corresponds to the first terminal H and the negative voltage supply rail 414 corresponds to the second terminal L. There is a P-channel metal oxide semiconductor transistor (PMOST) 420 with its source coupled to the positive voltage supply rail 412 and its drain coupled to the negative voltage supply rail 414 via a resistor 422. The gate of the bigFET 410 is coupled to the drain of the PMOST 420. There is a N-channel metal oxide semiconductor transistor (NMOST) 430 with its source and drain coupled to the negative voltage supply rail 414 and its gate coupled to the positive voltage supply rail 412 via a resistor 432. The gate of the PMOST 420 is coupled to the gate of the NMOST 430. There is a diode 442 with its anode coupled to the negative voltage supply rail 414 and its cathode coupled to the positive voltage supply rail 412.

In the absence of an electrostatic charge, the clamp 400 will not draw any current. Furthermore, simulations show that the clamp 400 does not trigger during power up, provided the power-up rise time is longer than about 10*µ*s.

The PMOST 420, resistor 422, NMOST 430, and resistor 432 in combination form a trigger circuit. An ESD typically happens when the integrated circuit 300 is not powered up. In the presence of an ESD which causes the voltage of the positive voltage rail 412 to rise relative to the voltage of the negative voltage rail 414, the voltage on the drain of the PMOST 420 rises, thereby causing the bigFET 410 to conduct the ESD current. The NMOST 430 functions as a capacitive element and charges through the resistor 432, thereby causing the voltage at the gate of the PMOST 420 to rise. The time constant of this charging is typically about 0.25*µ*s. When the voltage difference between the gate and the source of the PMOST 420 falls below a threshold voltage, which occurs after about 1.3*µ*s, the PMOST 420 ceases to conduct, thereby causing the voltage difference between the gate and the source of the bigFET 410 to fall to zero. Consequently the bigFET 410 ceases to conduct after the electrostatic charge has discharged, so enabling normal operation of core circuits coupled to the positive and negative voltage rails 412, 414.

In the presence of an ESD which causes the voltage of the negative voltage rail 414 to rise relative to the voltage of the positive voltage rail 412, the ESD current can take flow through the diode 442 which present a low impedance to an ESD of such a polarity, and which therefore do not require a trigger mechanism. Therefore, the first voltage drop V_{HL} is the voltage across the bigFET 410 during conduction of the ESD current through the bigFET 410, and the second voltage V_{LH} drop is the voltage across the diode 442 during conduction of the ESD current through the diode 442.

Simulations have shown that two of the clamps 312a-i coupled in series can be triggered by an ESD and remain in a high impedance state in normal operation in the absence of an ESD. The clamps 312a-i are isolated in a deep nwell for use with negative supply voltages, the deep nwell being coupled to the fifth interconnection pin 306e at the first positive supply voltage Vₚₒₛ, and the isolated pwell being coupled to the sixth interconnection pin 306f at the first negative supply voltage V_{neg}.

From simulations of 65nm integrated circuit technology, it is known that the voltage across a bigFET 410 is about 4V, corresponding to V_{HL}, and across the forward biased diode 442 is about 1.5V, corresponding to V_{LH}. Therefore, the worst case voltage drop is about 9.6V, corresponding to 2V_{HL}+V_{LH}. Damage to the core circuit 302 occurs once the voltage anywhere in the core circuit 302 exceeds the gate breakdown voltage, which is 12.5V for thick oxide transistors under ESD conditions for the present 65nm technology. The same value applies for a broad range of technologies which have a thick gate oxide of 5nm. In other technologies, with other gate oxide thickness, the proper breakdown voltage for such oxide thickness can be used. This means that, even in the worst case ESD current path, there is still a margin of about 3V before any damage to a thick oxide core circuit 302 occurs. In practice, part of this margin is required due to the voltage drop across the rail resistance. Such a margin would be sufficient for rail resistance up to about 1Ωand since in practice the rail resistance is typically significantly less than this, the rail resistance does not normally present a significant limitation to the ESD protection.

Other embodiments of an active clamp may alternatively be used. For example, the clamp may employ a slew rate trigger circuit that triggers dependent on the slew rate of the change of voltage difference between positive and negative voltage supply rails. The type of clamp can be freely chosen, as long as the voltage requirements defined above are met.

In the embodiments described above, the common conductor CC is separate to the substrate of the integrated circuit 300. However, the substrate can alternatively be employed as the common conductor CC. In this case, the anti-parallel diodes 314 can be omitted.

Other variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable subcombination.

It should be noted that the term "comprising" does not exclude other elements or steps, the term "a" or "an" does not exclude a plurality, a single feature may fulfil the functions of several features recited in the claims and reference signs in the claims shall not be construed as limiting the scope of the claims.

## Claims

**1.** An integrated circuit (300) comprising:
one or more positive interconnection means (306d, 306e, 306i) for coupling the integrated circuit (300) externally to the integrated circuit (300) at a voltage that is solely positive with respect to a common conductor (CC);
one or more negative interconnection means (306f-h) for coupling the integrated circuit (300) externally to the integrated circuit (300) at a voltage that is solely negative with respect to the common conductor (CC); and
a plurality of electrostatic discharge protection devices (312d-i) for conducting an electrostatic discharge current during the electrostatic discharge;
wherein the positive and negative interconnection means (306d-i) are each electrically coupled to the common conductor (CC) via a different one of the electrostatic discharge protection devices (312d-i) such that between each combination of two of the interconnection means (306d-i) is a first path for conducting the electrostatic discharge current, each first path comprising the common conductor (CC) and no more than two of the electrostatic discharge protection devices (312d-i).

**2.** An integrated circuit (300) as claimed in claim 1, wherein positive and negative interconnection means (306d-i) are all associated with a single domain of the integrated circuit (300).

**3.** An integrated circuit (300) as claimed in claim 1 or claim 2, wherein each of the electrostatic discharge protection devices (312d-i) coupled between the positive and negative interconnection means (306d-i) comprises a first terminal (H), a second terminal (L), a first protection element coupled between the first and second terminals (H, L) and a second protection element coupled between the first and second terminals (H, L), wherein:
the first protection element is arranged to present a relatively high impedance in the absence of an electrostatic voltage between the first and second terminals (H, L) and to switch temporarily to a relatively low impedance for conducting the electrostatic discharge current from the first terminal (H) to the second terminal (L) in the presence of the electrostatic voltage;
the second protection element is arranged to present a relatively high impedance from the first terminal (H) to the second terminal (L) and a relatively low impedance from the second (L) terminal to the first terminal (H) for conducting the electrostatic discharge current from the second terminal (L) to the first terminal (H) in the presence of the electrostatic voltage; and
for each one of the electrostatic discharge protection devices (312d-i) coupled between the positive and negative interconnection means (306d-i) the first and second terminals (H, L) are coupled in one of:
a first configuration in which the first terminal (H) is coupled to one of the positive interconnection means (306d, 306e, 306i) and the second terminal (L) is coupled to the common conductor (CC); and
a second configuration in which the first terminal (H) is coupled to the common conductor (CC) and the second terminal (L) is coupled to one of the negative interconnection means (306f-h).

**5.** An integrated circuit (300) as claimed in claim 4, wherein a part (302, 310) of the integrated circuit (300) to be protected from the electrostatic discharge has a breakdown voltage (V_{B}) at which damage is caused to the part (302, 310), each electrostatic discharge protection device (312d-i) coupled between the positive and negative interconnection means (306d-i), when conducting the electrostatic discharge current from the first terminal (H) to the second terminal (L) has a first voltage drop of (V_{HL}) and when conducting the electrostatic discharge current from the second terminal (L) to the first terminal (H) has a second voltage drop (V_{LH}), and both twice the first voltage drop (V_{HL}) and twice the second voltage drop (V_{LH}) are each less than the breakdown voltage (V_{B}).

**6.** An integrated circuit (300) as claimed in claim 4 or claim 5, wherein the first protection element comprises a switchable transistor (410) and the second protection element comprises a diode (442).

**7.** An integrated circuit (300) as claimed in any one of the preceding claims, further comprising a dual polarity interconnection means (306a) for coupling the integrated circuit (300) externally to the integrated circuit (300) at a voltage that varies between positive and negative with respect to the common conductor (CC),
wherein the dual polarity interconnection means (306a) is coupled to one of the positive interconnection means (306d, 306e, 306i) via another different one of the electrostatic discharge protection devices (312a) and is coupled to one of the negative interconnection means (306f-h) via yet another different one of the electrostatic discharge protection devices (306b) such that between the dual polarity interconnection means (306a) and the one of the positive interconnection means (306d, 306e, 306i) is a second path for conducting the electrostatic discharge current, and between the dual polarity interconnection means (306a) and the one of the negative interconnection means (306f-h) is another second path for conducting the electrostatic discharge current, each second path comprising no more than one of the electrostatic discharge protection devices (312a, 312b).

**8.** An integrated circuit (300) as claimed claim 8, wherein the one of the positive interconnection means (306d, 306e, 306i) to which the dual polarity interconnection means (306a) is coupled is at a voltage that is a positive supply voltage for a/the part (302, 310) of the integrated circuit (300) to be protected from the electrostatic discharge and the one of the negative interconnection means (306f-h) to which the dual polarity interconnection means (306a) is coupled is at a voltage that is a negative supply voltage for the part (302, 310) of the integrated circuit (300) to be protected from an electrostatic discharge.

**9.** An integrated circuit (300) as claimed in claim 8, wherein the positive supply voltage and negative supply voltage are respectively the most positive and most negative supply voltages of the integrated circuit (300).

**10.** An integrated circuit (300) as claimed in any one of claims 7 to 9, wherein each of the electrostatic discharge protection devices (312a, 312b) coupled between the dual polarity interconnection means (306a) and the ones of the positive and negative interconnection means (306d-i) comprises a first terminal (H), a second terminal (L), a first protection element coupled between the first and second terminals (H,L) and a second protection element coupled between the first and second terminals (H,L), wherein:
the first protection element is arranged to present a relatively high impedance in the absence of an electrostatic voltage between the first and second terminals (H, L) and to switch temporarily to a relatively low impedance for conducting the electrostatic discharge current from the first terminal (H) to the second terminal (L) in the presence of the electrostatic voltage;
the second protection element is arranged to present a relatively high impedance from the first terminal (H) to the second terminal (L) and a relatively low impedance to from the second terminal (L) to the first terminal (H) for conducting the electrostatic discharge current from the second terminal (L) to the first terminal (H) in the presence of the electrostatic voltage; and
for each one of the electrostatic discharge protection devices (312a, 312b) coupled between the dual polarity interconnection means (306a) and the ones of the positive and negative interconnection means (306d-i), the first and second terminals (H, L) are coupled in one of:
a first configuration in which the first terminal (H) is coupled to the dual polarity interconnection means (306a) and the second terminal (L) is coupled to the one of the negative voltage interconnection means (306f-h); and
a second configuration in which the first terminal (H) is coupled to the one of the positive voltage interconnection means (306d, 306e, 306h) and the second terminal (L) is coupled to the dual polarity interconnection means (306a).

**11.** An integrated circuit (300) as claimed in claim 10, wherein a/the part (302, 310) of the integrated circuit (300) to be protected from the electrostatic discharge has a breakdown voltage (V_{B}) at which damage is caused to the part (302, 310), each electrostatic discharge protection device (312a, 312b) coupled between the dual polarity interconnection means (306a) and the ones of the positive and negative interconnection means (306d-i), when conducting the electrostatic discharge current from the first terminal (H) to the second terminal (L) has a first voltage drop (V_{HL}) and when conducting the electrostatic discharge current from the second terminal (L) to the first terminal (H) has a second voltage drop (V_{LH}), and both the total of the second voltage drop (V_{LH}) plus twice the first voltage drop (V_{HL}) and the total of the first voltage drop (V_{HL}) plus twice the second voltage drop (V_{LH}) are each less than the breakdown voltage (V_{B}).

**12.** An integrated circuit as claimed in claim 11, wherein each electrostatic discharge protection device (312d-i) coupling the positive and negative interconnection means (306d-i) to the common conductor CC, when conducting the electrostatic discharge current from the first terminal (H) to the second terminal (L) has a first voltage drop (V_{HL}) and when conducting the electrostatic discharge current from the second terminal (L) to the first terminal (H) has a second voltage drop (V_{LH}), and both the total of the second voltage drop (V_{LH}) plus twice the first voltage drop (V_{HL}) and the total of the first voltage drop (V_{HL}) plus twice the second voltage drop (V_{LH}) are each less than the breakdown voltage (V_{B}).

**13.** An integrated circuit (300) as claimed in any preceding claim, wherein the common conductor (CC) comprises a substrate of the integrated circuit (300).

**14.** A method of protecting an integrated circuit (300) from an electrostatic discharge, the integrated circuit (300) comprising one or more positive interconnection means (306d, 306e, 306i) for electrically coupling the integrated circuit (300) externally to the integrated circuit (300) at a voltage that is solely positive with respect to a common conductor (CC) and one or more negative interconnection means (306f-h) for electrically coupling the integrated circuit (300) externally to the integrated circuit (300) at a voltage that is solely negative with respect to the common conductor (CC), the method comprising employing a plurality of electrostatic discharge protection devices (312d-i) for conducting an electrostatic discharge current by electrically coupling each of the positive and negative interconnection means (306d-i) to the common conductor (CC) via a different one of the electrostatic protection devices (312d-i) such that between each combination of two of the interconnection means (312d-i) is a first path for conducting the electrostatic discharge current, each first path comprising the common conductor (CC) and no more than two of the electrostatic discharge protection devices (312d-i).
